Europäisches Patentamt

European Patent Office

Office européen des brevets

(19)

(11) **EP 0 617 491 B1**

(12) **EUROPÄISCHE PATENTSCHRIFT**

(45) Veröffentlichungstag und Bekanntmachung des Hinweises auf die Patenterteilung:
**31.07.1996 Patentblatt 1996/31**

(51) Int Cl.⁶: **H01S 3/19**, H01L 33/00

(21) Anmeldenummer: **94104050.3**

(22) Anmeldetag: **16.03.1994**

(54) **Lichtemittierendes Halbleiterbauelement**

Light-emitting semiconductor element

Elément semi-conducteur à l'émission de lumière

(84) Benannte Vertragsstaaten:
**DE FR GB IT NL**

(30) Priorität: 26.03.1993 DE 4310569
26.03.1993 DE 4310571

(43) Veröffentlichungstag der Anmeldung:
**28.09.1994 Patentblatt 1994/39**

(73) Patentinhaber: **Daimler-Benz Aktiengesellschaft
D-70546 Stuttgart (DE)**

(72) Erfinder: **Ebeling, Karl Joachim, Prof. Dr.
D-89075 Ulm (DE)**

(74) Vertreter: **Weber, Gerhard, Dipl.-Phys. et al
AEG Aktiengesellschaft
60591 Frankturt (DE)**

(56) Entgegenhaltungen:
**EP-A- 0 487 823**

- **APPLIED PHYSICS LETTERS., Bd.59, Nr.21, 18. November 1991, NEW YORK US Seiten 2634 - 2635 H.K. CHOI ET AL 'GaAs-based diode lasers on Si with increased lifetime obtained by using strained InGaAs active layer'**
- **SOLID STATE ELECTRONICS, Bd.30, Nr.9, 1987, OXFORD GB Seiten 901 - 906 D.P MUNICH ET AL 'crystal structure and band-gap of AlGaAsN'**
- **ELECTRO 1989 APRIL 11-13 1989, J.K. JAVITS CONVENTION CENTER, CONFERENCE RECORD Seite 1-4 S.Y. NARAYAN ET AL 'GaAS- on Si technology'**
- **PATENT ABSTRACTS OF JAPAN vol. 17, no. 13 (E-1304) 11. Januar 1993 & JP-A-04 242 985 (TOYODA GOSEI CO LTD)**

**Beschreibung**

Die Erfindung betrifft ein lichtemittierendes Halbleiterbauelement mit einer auf ein Siliziumsubstrat aufgewachsenen Schichtenfolge aus einem III-V-Verbindungshalbleitermaterial.

Derartige Bauelemente sind beispielsweise bekannt als Leuchtdioden mit InAlGaAs-Verbindungshalbleitern auf Silizium. Nachteilig an den bisher bekannten Leuchtdioden ist die geringere Quantenausbeute aufgrund von durch Gitterverzerrungen verursachte nichtstrahlende Rekombination und für die Verwendung in der Anzeigetechnik die Emission im Infrarctbereich. Für gleichfalls bekannte im infraroten Spektralbereich emittierende Laserdioden werden bei der Herstellung aufwendige Pufferschichten zum Auffangen von Versetzungslinien auf das Siliziumsubstrat aufgewachsen. Das Wandern von Versetzungen in die aktive Zone, was den Ausfall des Lasers zur Folge hat, läßt sich aber letztendlich nicht vollkommen unterdrücken.

Aus dem Artikel "GaAs-based diode lasers on Si with increased lifetime obtained by using strained InGaAs active layer", der in Applied Physics Letters 50(1991)21, Seiten 2634-2635 veröffentlicht wurde, ist eine auf einem Si-Substrat aufgewachsene III-V Laserdiode bekannt. In der europäischen Patentanmeldung EP-A-0 487 823 wird ein lichtemittierendes Halbleiterbauelement mit einem ZnO-Substrat und darauf aufgewachsenen, gitterangepaßten AlGaAsN-Schichten offenbart.

Aufgabe der vorliegenden Erfindung ist es, ein lichtemittierendes Halbleiterbauelement auf Silizium-Substrat mit hoher Effizienz und langer Lebensdauer anzugeben.

Die Erfindung ist im Patentanspruch 1 beschrieben. Die Unteransprüche enthalten vorteilhafte Ausgestaltungen und Weiterbildungen der Erfindung.

Wesentlich an der Erfindung ist die Gitteranpassung an das Silizium-Substrat. Der Anteil $x$ von Stickstoff gegenüber Arsen in der B(V)-Komponente $As_{1-x}N_x$ des A(III)-B(V)-Verbindungshalbleitermaterials liegt hierfür vorzugsweise zwischen 0,1 und 0,2. Die realative Differenz in den Gitterkonstanten ist vorzugsweise $<10^{-3}$. Mit Gallium als Hauptbestandteil der A(III)-Komponente in der aktiven Schicht ergibt sich ein direkter Bandübergang für die Lichtemission, deren Wellenlänge über den Gehalt von Aluminium und in geringerem Maße auch Indium in der A(III)-Komponente InAlGa der aktiven Schicht von ca. 500nm bis über 800nm gezielt eingestellt werden kann, so daß günstigerweise eine Emission im sichtbaren Bereich erzielt werden kann.

Die Erfindung ist nachfolgend anhand von Ausführungsbeispielen unter Bezugnahme auf die Abbildungen noch eingehend veranschaulicht.

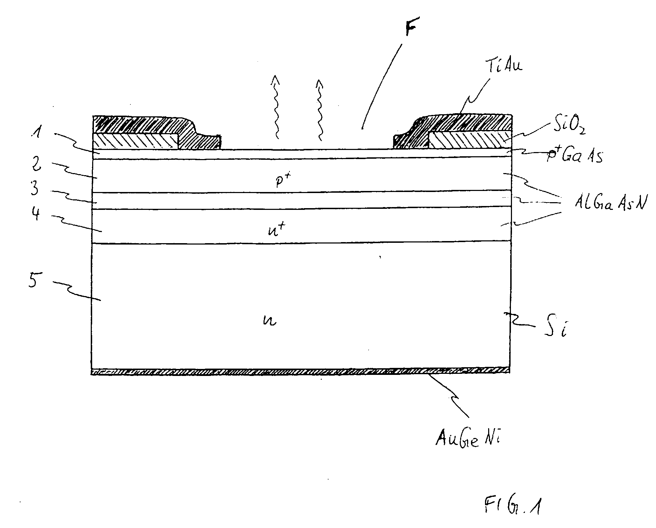

Der in FIG. 1 nicht maßstabgetreu skizzierte Aufbau einer Leuchtdiode mit einer Halbleiterschichtenfolge 1 bis 5 weist als unterste Schicht ein n-dotiertes Si-Substrat auf, auf welches eine an das Substrat gitterangepaßte n-dotierte $AlGaAs_{1-x}N_x$ $(0,1 \leq x \leq 0,2)$ Cladding Schicht 4 als ca. 500nm dicke Zwischenschicht mit einer Dotierung $n \approx 3 \cdot 10^{18}$ cm$^{-3}$ aufgewachsen ist. Die Heterobarriere zwischen Schicht 4 und dem Substrat läßt sich durch eine Graduierung reduzieren, die insbesondere den Heterowiderstand vermindert.

Auf die Claddingschicht 4 ist eine ca. 100nm dicke aktive Schicht 3 aus an das Si-Substrat gitterangepaßtem $Al_yGa_{1-y}As_{1-x}N_x$ mit 2-3 verspannten 5-8nm dicken $Al_yGa_{1-y}As$ Quantenwell-Schichten aufgewachsen. Die gesamte aktive Schicht ist undotiert. Mit beispielsweise $y \approx 0,1$ liegt die Wellenlänge der Lichtemission zwischen 600 und 700nm.

In den Quantenwellschichten kann teilweise Gallium gegen Indium ausgetauscht und auf diese Weise durch Kontrolle der Verspannung eine Feinabstimmung der Emissionswellenlänge vorgenommen werden.

Auf die aktive Schicht 3 folgt eine weitere ca. 500nm dicke Claddingschicht 2 die wie die Schicht 4 aus an das Si-Substrat gitterangepaßtem $AlGaAs_{1-x}N_x$ besteht.

Die auf die aktive Schicht 3 aufgewachsene Schicht 2 ist wieder eine ca. 500nm dicke Claddingschicht und besteht wie die Claddingschicht 4 aus $AlGaAs_{1-x}N_x$. Sie ist p-dotiert mit einer Konzentration von $p \approx 5 \cdot 10^{18}$cm$^{-3}$. Der Al-Gehalt in den Cladding-Schichten 2 und 4 ist so groß zu wählen, daß die Bandlücke energetisch größer ist als in der aktiven Schicht. Zur Kontaktierung ist eine abschließende ca. 20nm dicke Kontaktschicht aus p$^+$-GaAs vorgesehen, die mit einem metallischen Kontakt aus beispielsweise TiAu versehen ist. Die metallische Schicht ist in den Randbereichen durch eine dielektrische Schicht, z.B. aus SiO$_2$ gegen die Kontaktschicht isoliert und läßt ein Fenster F für den Austritt des emittierten Lichts frei. Für den gegenpoligen Kontakt kann beispielsweise auf die Unterseite des Si-Substrats eine metallische AuGeNi-Schicht aufgebracht sein.

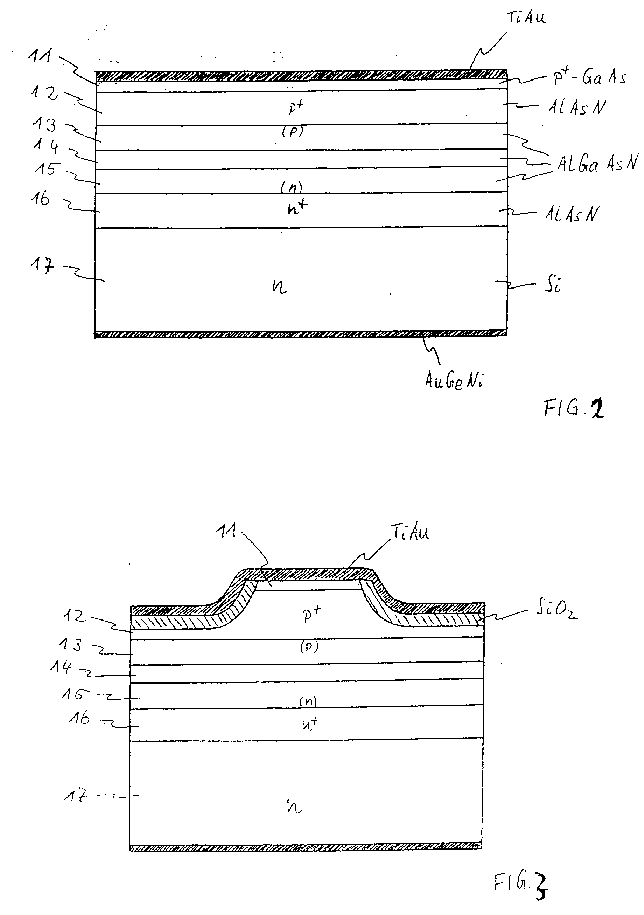

Der in FIG. 2 skizzierte Aufbau einer Laserdiode mit einer Halbleiterschichtenfolge 11 bis 17 weist als unterste Schicht ein n-dotiertes Si-Substrat auf, auf welches eine an das Si-Substrat gitterangepaßte n$^+$-$AlAs_{1-x}N_x$ $(0,1 \leq x \leq 0,2)$ Cladding-Schicht 16 als 1-2µm dicke Zwischenschicht mit einer Dotierung $n \approx 5 \cdot 10^{18}$ cm$^{-3}$ aufgewachsen ist. Auf diese folgt eine an das Si-Gitter angepaßte Graduierungsschicht 15 aus $AlGaAs_{1-x}N_x$ mit einer Dicke von ca. 250nm, deren untere, d.h. der Cladding-Schicht 16 zugewandte Hälfte n-dotiert ist. Auf die Graduierungssschicht 15 ist eine 50-100nm dicke laseraktive Schicht aus an das Si-Substrat gitterangepaßtem $Al_yGa_{1-y}As_{1-x}N_x$ mit 2-3 verspannten, 5-8nm dicken $Al_yGa_{1-y}$ As Quantenwell-Schichten aufgewachsen. Die gesamte aktive Schicht ist undotiert. Mit $y \approx 0,1$ liegt die Wellenlänge der Laseremission zwischen 600 und 700nm. In den Quantenwellschichten kann teilweise Gallium gegen Indium ausgetauscht und auf diese Weise durch Kontrolle der Verspannung eine Feinabstimmung der Emissionswellenlänge und des Gewinns vorgenommen werden.

Auf die aktive Schicht 14 folgt eine weitere ca. 250nm dicke Graduierungsschicht 13, die wie die Schicht 15 aus an das Si-Substrat gitterangepaßtem $AlGaAs_{1-x}N_x$ besteht. Sie ist in ihrer oberen, d.h. der aktiven Schicht 14 abgewandten Hälfte p-dotiert. Die beiden Graduierungsschichten und die von ihnen eingeschlossene aktive Schicht bilden einen optischen Wellenleiter.

Die Schicht 12 ist wieder eine 1-2μm dicke Cladding-Schicht und besteht wie die Cladding-Schicht 16 aus $AlAs_{1-x}N_x$. Sie ist p⁺-dotiert mit einer Konzentration von $p \approx 5 \cdot 10^{18} cm^{-3}$

Zur Kontaktierung ist eine abschließende ca. 20nm dicke Kontaktschicht aus p⁺-GaAs mit $p \approx 5 \cdot 10^{18} cm^{-3}$ vorgesehen, die mit einem metallischen Kontakt aus beispielsweise TiAu versehen ist. Für den gegenpoligen Kontakt kann beispielsweise auf die Unterseite des Si-Substrats eine metallische AuGeNi-Schicht aufgebracht sein.

Die Spiegelflächen können beispielsweise durch Trockenätzen oder durch Spalten auf Kristallflächen (111) oder ($\overline{1}\overline{1}\overline{1}$) erzeugt werden. Eine äquivalente Schichtenfolge auf einem p-dotierten Substrat ergibt sich unmittelbar durch Austausch der Dotierungstypen in den einzelnen Schichten.

FIG. 3 zeigt die Frontansicht einer Laserdiode in Rippenwellenleiter-Ausführung, bei welcher die Kontaktschicht 11 nur auf einer Rippenbreite von beispielsweise 2-4μm stehen bleibt und auch die 1-2μm dicke Cladding-Schicht 12 in den Randbereichen bis auf eine Restdicke von 100-200nm abgetragen ist. Die ganzflächig abgeschiedene TiAu-Metallschicht ist gegen die Cladding-Schicht 12 durch eine dielektrische Schicht aus beispielsweise $SiO_2$ isoliert. Der Schichtenaufbau entspricht im übrigen der FIG. 2.

Zu den skizzierten vorteilhaften Ausführungen der Leuchtdiode oder der Laserdioden alternative Ausführungen und Bauformen lichtemittierender Bauelemente wie beispielsweise eine Laserdiode mit vertikalem Laserresonator, BH-Bauform oder DCPBH-Bauform u.ä., wie sie aus dem Stand der Technik bekannt sind, sind selbstverständlich auch mit der vorliegenden Erfindung möglich.

Die Herstellung einer der beschriebenen Schichtenfolgen kann beispielsweise mittels Molekularstrahlepitaxie (MBE) oder MO(metall organic)MBE in an sich bekannter Weise erfolgen. Zur p-Dotierung kann beispielsweise Beryllium, zur n-Dotierung Silizium dienen.

Die erfindungsgemäßen lichtemittierenden Bauelemente sind durch das Aufwachsen auf ein Silizium-Substrat besonders zur monolithischen Integration mit weiteren Bauelementen oder mit vollständigen integrierten Schaltkreisen in Silizium-Technologie geeignet und vor allem für die optische Verbindungs- und Kommunikationstechnik, aber auch für die Anzeige- und Beleuchtungstechnik vorteilhaft.

**Patentansprüche**

1. Lichtemittierendes Halbleiterbauelement mit einer auf ein Siliziumsubstrat aufgewachsenen Schichtenfolge aus III-V-Verbindungshalbleitermaterial, das eine Materialkomponente A der III. Gruppe des Periodensystems und eine Materialkomponente B der V. Gruppe des Periodensystems enthält, <u>dadurch gekennzeichnet,</u> daß das Verbindungshalbleitermaterial an das Siliziumsubstrat gitterangepaßt ist und als Materialkomponente B $As_{1-x}N_x$ enthält.

2. Bauelement nach Anspruch 1, dadurch gekennzeichnet, daß die aktive Schicht als Materialkomponente A überwiegend Gallium enthält.

3. Bauelement nach Anspruch 1 oder 2, dadurch gekennzeichnet, daß die aktive Schicht der Schichtenfolge aus AlGaAsN mit mehreren eingebetteten verspannten Quantenwell-Schichten aus AlGaAs besteht.

4. Bauelement nach Anspruch 2 oder 3, dadurch gekennzeichnet, daß die aktive Schicht undotiert ist.

5. Bauelement nach Anspruch 3, dadurch gekennzeichnet, daß die Quantenwell-Schichten zusätzlich In enthalten.

6. Bauelement nach einem der Ansprüche 1 bis 5 gekennzeichnet durch die Emission von Licht im sichtbaren Bereich.

7. Bauelement nach einem der vorhergehenden Ansprüche, gekennzeichnet durch die monolithische Integration mit Silizium-Bauelementen.

8. Bauelement nach einem der Ansprüche 1 bis 7, gekennzeichnet durch seine Ausführung als Leuchtdiode.

9. Bauelement nach einem der Ansprüche 1 bis 7, gekennzeichnet durch seine Ausführung als Laserdiode.

**Claims**

1. Light-emitting semiconductor component with a layer sequence which is grown on a silicon substrate and consists of III-V connecting semiconductor material, which contains a material component A of the III group of the periodic system and a material component B of the V group of the periodic system, characterised thereby that the connecting semiconductor material is matched in lattice to the silicon substrate and contains $As_{1-x}N_x$ as material compo-

nent B.

2. Component according to claim 1, characterised thereby, that the active layer contains predominantly gallium as material component A.

3. Component according to claim 1 or 2, characterised thereby that the active layer of the layer sequence consists of A1GaAsN with several embedded strained quanta well layers of A1GaAs.

4. Component according to claim 2 or 3, characterised thereby that the active layer is undoped.

5. Component according to claim 3, characterised thereby that the quanta well layers additionally contain In.

6. Component according to one of claims 1 to 5, characterised by the emission of light in the visible range.

7. Component according to one of the preceding claims, characterised by the monolithic integration with silicon components.

8. Component according to one of claims 1 to 7, characterised by its realisation as a luminescent diode.

9. Component according to one of claims 1 to 7, characterised by its realisation as a laser diode.

**Revendications**

1. Composant semi-conducteur émetteur de lumière équipé d'une succession de couches déposées sur un substrat de silicium en un matériau semi-conducteur composé III-V, qui contient un constituant A du groupe III de la classification périodique et un matériau B du groupe V de la classification périodique, caractérisé en ce que le matériau semi-conducteur composé est adapté à la structure cristalline du substrat de silicium et contient en tant que matériau B $As_{1-x}N_x$.

2. Composant selon la revendication 1, caractérisé en ce que la couche active contient principalement en tant que matériau A du gallium.

3. Composant selon la revendication 1 ou 2, caractérisé en ce que la couche active de la succession de couches se compose de AlGaAsN avec plusieurs couches de puits quantique déformées noyées en AlGaAs.

4. Composant selon la revendication 2 ou 3, caractérisé en ce que la couche active n'est pas dopée.

5. Composant selon la revendication 3, caractérisé en ce que les couches de puits quantique contiennent en outre In.

6. Composant selon l'une des revendications 1 à 5, caractérisé par l'émission de lumière dans le spectre visible.

7. Composant selon l'une des revendications précédentes, caractérisé par l'intégration monolithique avec des composants au silicium.

8. Composant selon l'une des revendications 1 à 7, caractérisé par sa réalisation en tant que diode électroluminescente.

9. Composant selon l'une des revendications 1 à 7, caractérisé par sa réalisation en tant que diode laser.

F

TiAu

SiO₂

1

2

3

4

5

p⁺

n⁺

n

p⁺GaAs

AlGaAsN

Si

AuGeNi

FIG. 1

FIG. 2

FIG. 3